# EUROPEAN PATENT APPLICATION

(11) **EP 1 369 737 A2**
(43) Date of publication of application: **10.12.2003**
(21) Application number: 03253526.2
(22) Date of filing: 05.06.2003
(51) Int. Cl.: G02F 1/13, H05K 1/02

(54) **Liquid crystal display device and manufacturing method thereof**

(30) Priority: 06.06.2002 JP 2002165433; 06.06.2002 JP 2002165434
(71) Applicant: ALPS ELECTRIC CO., LTD., Ota-ku Tokyo 145 (JP)
(72) Inventor: Miki, Yasuhiro, Tokyo 145 (JP); Masumoto, Yoshifumi, Tokyo 145 (JP); Kusano, Manabu, Tokyo 145 (JP); Owada, Ko, Tokyo 145 (JP)
(74) Representative: Enskat, Michael Antony Frank

(57) **Abstract**

A liquid crystal display device (1) having a pair of transparent substrates (11,12) facing each other with a liquid crystal layer sandwiched, transparent electrodes (21,31), interconnect wirings (14,35), a control circuit device (13) wherein an electrode pad (14a,35a) to be connected to an original terminal of the control circuit device is formed at the tip ends of the interconnect wirings, and an island transparent dummy pad (20) to be connected to a dummy terminal of the control circuit device is disposed, the island transparent dummy pad is adjacent to the electrode pads but separate from the interconnect wirings.

## Description

### BACKGROUND OF THE INVENTION

### 1. Field of the Invention

The present invention relates to a liquid crystal display device, particularly to a liquid crystal display device in which interconnect wirings are formed of a metal film to improve display performance.

### 2. Description of the Related Art

To response to reductions in size and costs of recent electronic devices, such devices have been adopted as two driver ICs for an STN (Super-Twisted Nematic) liquid crystal display device are combined in a single IC. More specifically, two driver ICs connected to each of traditional common and segment transparent electrodes are gathered on one side of a panel, and the two driver ICs are replaced by a single driver IC for driving.

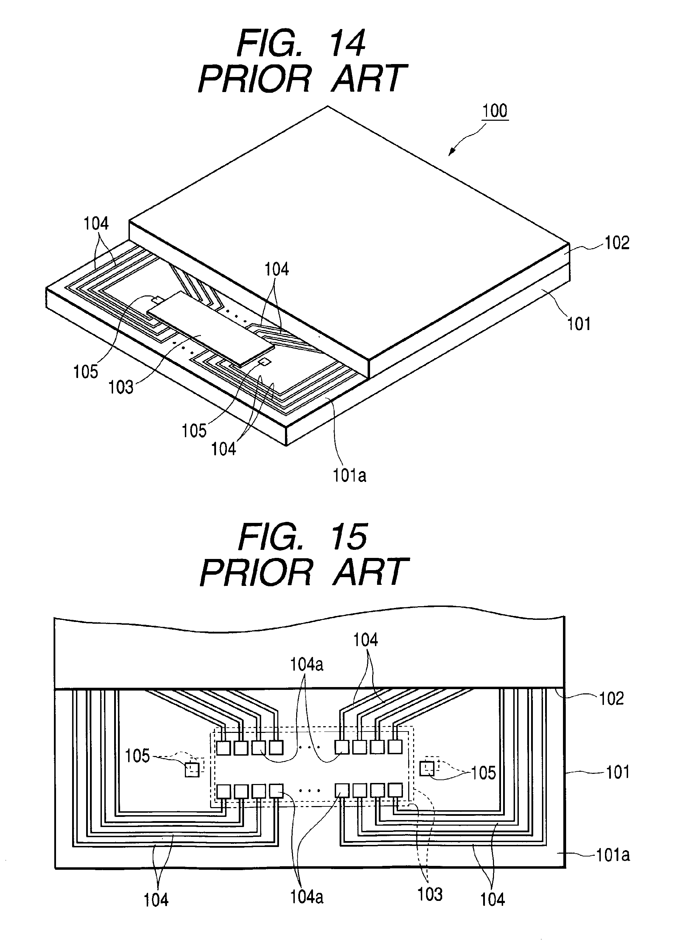

Fig. 14 depicts a perspective view illustrating a traditional liquid crystal display device, and Fig. 15 depicts a plan view illustrating an essential part of the traditional liquid crystal display device.

As shown in Fig. 14, a traditional liquid crystal display device 100 is mainly configured of a pair of transparent substrates (first and second substrates) 101 and 102 facing each other with a liquid crystal layer sandwiched, not shown, and a control IC 103 disposed on an exposed surface 101a of the first substrate 101. The first substrate 101 is formed longer in length than the second substrate 102, and the portion extending off the second substrate 102 is formed to be the exposed surface 101a.

On the surfaces of the substrates 101 and 102 on the liquid crystal layer side, common and segment transparent electrodes made of ITO (Indium Tin Oxide) are formed, respectively.

As shown in Figs. 14 and 15, interconnect wirings 104 for connecting each of the transparent electrodes to the control IC 103 are drawn on the exposed surface 101a of the first substrate 101. The interconnect wiring 104 is formed of a layered product of an ITO film and a metal film in which at least a part of the metal film is overlapped with the ITO film.

As shown in Fig. 15, an island electrode pad 104a made of the metal film is formed on the tip end of each of the interconnect wirings 104, and terminals of the control IC 103 (not shown) are bonded to the electrode pads 104a.

To form the interconnect wirings 104 including the electrode pads 104a, a photomask for use in forming the segment transparent electrodes is fist used to form the ITO film configuring the interconnect wirings 104 at the same time when the transparent electrodes are formed, and then another photomask is used to form the metal film.

As shown in Figs. 14 and 15, on both sides of the control IC 103 on the exposed surface 101a, alignment marks 105, 105 are formed that are the reference for positioning the control IC 103 in mounting the control IC 103 on the first substrate 101. The alignment marks 105, 105 are made of ITO, for example, as similar to the transparent electrodes. They are formed by the photomask for the segment transparent electrodes at the same time when the transparent electrodes are formed.

To mount the control IC with the use of the alignment marks 105, a liquid crystal display device is assembled and then is delivered to a mounting device for the control IC. Subsequently, a sensor inside the mounting device senses the positions of the alignment marks 105, 105 from under the first transparent substrate 101, and the liquid crystal display device is fixed at a predetermined position of a jig inside the mounting device for positioning based on position data at this time. In this state, the control IC 103 is placed on the exposed surface 101a through an anisotropic conductive tape, and the terminals of the control IC are positioned and bonded to the electrode pads 104a of the exposed surface 101a.

Therefore, to mount the control IC 103 highly accurately, the relative positions of the alignment marks 105 to the electrode pads 104a are required to be highly accurate.

### SUMMARY OF THE INVENTION

However, in the traditional liquid crystal display device, the alignment marks 105 made of ITO are formed by using the photomask separate from that used for forming the electrode pads 104a made of the metal film, as described above. Thus, the alignment marks 105 are sometimes formed at positions (the positions indicated by a dashed line in Fig. 15) slightly shifted from the original positions. There is a problem that the positions of the alignment marks are slightly shifted to cause the position of mounting the control IC 103 to be shifted to the position surrounded by a long dashed double-short dashed line in accordance with this, and the terminals of the control IC 103 cannot be bonded to predetermined electrode pads 104a.

In addition, since the opaque anisotropic conductive tape is interposed between the terminals of the control IC 103 and the electrode pads 104a, the terminals cannot be visually recognized from under the substrate 101 directly. Consequently, a bonding state of the terminals to the electrode pads 104a cannot be directly observed. Therefore, the bonding state is inspected by testing whether they are electrically connected. On this account, a unit for confirming the bonding state of the terminals to the electrode pads by direct observation is sought.

The invention has been made in view of the circumstances. An object is to provide a liquid crystal display device in which the control IC 103 can be mounted highly accurately and the bonded state of the control IC 103 can be observed easily, and a manufacturing method of the liquid crystal display device.

In order to achieve the object, the invention adopted the configurations below.

A liquid crystal display device of the invention is characterized by having:
a pair of substrates facing each other with a liquid crystal layer sandwiched;
transparent electrodes disposed on surfaces of the substrates on a side of the liquid crystal layer;
interconnect wirings for drawing each of the transparent electrodes to one of the substrates; and
a control circuit device disposed on the one substrate and connected to the interconnect wirings,
wherein at least a part or all of the interconnect wirings are configured by laminating a metal film on a part or all of an ITO film,
alignment marks to be reference for positioning the control circuit device are formed on both sides of the control circuit device on the substrate, and
the alignment marks are formed of a same component material as that of the metal film of the interconnect wirings.

Preferably, a liquid crystal display device of the invention is characterized in that the alignment marks and the metal film of the interconnect wirings are formed at the same time.

Preferably, a liquid crystal display device of the invention is characterized in that the alignment marks and the metal film of the interconnect wirings are formed by forming the metal film on the one substrate and then patterning the metal film with a same mask.

According to the liquid crystal display device, the alignment marks and the metal film of the interconnect wirings are formed at the same time. Therefore, the relative positions of the alignment marks to the interconnect wirings can be set constant. Accordingly, the position to mount the control circuit device can be determined accurately.

Moreover, the alignment marks are made of the same component material as that of the metal film of the interconnect wirings. Thus, the alignment marks can be recognized along with the control circuit device from the side where the alignment marks are formed, and the control circuit device can be positioned accurately.

Preferably, a liquid crystal display device of the invention is characterized in that an electrode pad made of the metal film to be connected to a terminal of the control circuit device is formed at tip ends of the interconnect wirings, and the alignment marks and the electrode pads are formed at the same time.

According to the liquid crystal display device, the alignment marks and the electrode pads are formed at the same time. Therefore, the relative positions of the alignment marks to the electrode pads can be set constant. Accordingly, the terminals of the control circuit device can be accurately positioned and bonded to the electrode pads.

Preferably, a liquid crystal display device of the invention is characterized in that the electrode pads and the alignment marks are formed by forming a metal layer on the one substrate and then patterning the metal layer with a same mask.

According to the liquid crystal display device, the electrode pads and the alignment marks are formed by the same mask. Thus, the relative positions of the alignment marks to the electrode pads can be set constant.

According to another aspect of the present invention, there is provided a method of manufacturing a liquid crystal display device having a pair of substrates facing each other with a liquid crystal layer sandwiched, transparent electrodes disposed on surfaces of the substrates on a side of the liquid crystal layer, interconnect wirings for drawing each of the transparent electrodes to one of the substrates, and a control circuit device disposed on the one substrate and connected to the interconnect wirings, the manufacturing method is characterized by including:
forming a metal layer on the one substrate and then patterning the metal layer with a same mask to form alignment marks to be reference for positioning the control circuit device on both sides of the control circuit device at the same time when the interconnect wirings are formed.

According to the manufacturing method of the liquid crystal display device, the alignment marks and the metal film of the interconnect wirings are formed at the same time. Therefore, the relative positions of the alignment marks to the interconnect wirings can be set constant. Accordingly, the position to mount the control circuit device can be determined accurately.

Additionally, the alignment marks are made of the metal film. Therefore, the alignment marks can be recognized along with the control circuit device from the side where the alignment marks are formed, and the control circuit device can be positioned accurately.

Preferably, the manufacturing method is characterized in that an electrode pad made of the metal film to be connected to a terminal of the control circuit device is formed at tip ends of the interconnect wirings, and the alignment marks and the electrode pads are formed at the same time.

According to the manufacturing method of the liquid crystal display device, the alignment marks and the electrode pads are formed at the same time. Therefore, the relative positions of the alignment marks to the electrode pads can be set constant. Accordingly, the terminals of the control circuit device can be accurately positioned and bonded to the electrode pads.

Preferably, the method is characterized in that the electrode pads and the alignment marks are formed by patterning the metal layer with the mask.

According to the manufacturing method of the liquid crystal display device, the electrode pads and the alignment marks are formed with the same mask. Therefore, the relative positions of the alignment marks to the electrode pads can be set constant.

According to a further aspect of the present invention, there is provided a liquid crystal display device characterized by:
a pair of transparent substrates facing each other with a liquid crystal layer sandwiched;
transparent electrodes disposed on surfaces of the transparent substrates on a side of the liquid crystal layer;
interconnect wirings for drawing each of the transparent electrodes to one of the transparent substrates; and
a control circuit device disposed on the one transparent substrate and connected to the interconnect wirings,
wherein the control circuit device is formed with a dummy terminal not to be connected to the interconnect wiring,
an electrode pad to be connected to an original terminal of the control circuit device is formed at a tip end of each of the interconnect wirings, and
an island transparent dummy pad to be connected to the dummy terminal of the control circuit device is disposed, the island transparent dummy pad is adjacent to the electrode pad but separate from the interconnect wiring.

According to the liquid crystal display device, the island transparent dummy pad to be connected to the dummy terminal of the control circuit device, the island transparent dummy pad is adjacent to the electrode pad but separate from the interconnect wiring. Therefore, a bonding state of the dummy terminal to the transparent dummy pad can be visually recognized from the side where the interconnect wirings are not disposed on the one transparent substrate. Accordingly, the bonding state of the electrode pads to the original terminal s can be estimated from a bonding state of the transparent dummy pad to the dummy terminal, and a bonded state of the control circuit device can be visually recognized through the transparent dummy pad.

Preferably, at least a part or all of the interconnect wirings are configured by laminating a metal film on a part or all of an ITO film, the electrode pad is formed of at least the metal film, and the transparent dummy pad is formed of ITO.

According to the liquid crystal display device, at least a part or all of the interconnect wirings are formed by laminating the metal film on a part or all of the ITO film. Therefore, the conductivity of the interconnect wirings is improved to prevent display unevenness of the liquid crystal display device from being generated.

Moreover, the electrode pads are formed of the metal film. Therefore, resistance between the interconnect wirings and the control circuit device can be reduced. In addition to this, the transparent dummy pad is formed of ITO. Therefore, a bonding state of the dummy terminal to the transparent dummy pad can be visually recognized from the side where the interconnect wirings are not disposed on the one transparent substrate.

Preferably, a liquid crystal display device of the invention is characterized in that alignment marks made of the metal film to be reference for positioning the control circuit device are formed on both sides of the control circuit device on the transparent substrate, and the alignment marks and the electrode pads are formed at the same time.

According to the liquid crystal display device, the alignment marks are formed of the metal film and are formed at the same time with the electrode pads. Therefore, the relative positions of the alignment marks to the electrode pads can be set constant. Accordingly, the terminals of the control circuit device can be accurately positioned and bonded to the electrode pads.

Moreover, a liquid crystal display device of the invention is characterized in that the electrode pads and the alignment marks are formed by forming a metal layer on the one transparent substrate and then patterning the metal layer with a same mask.

According to the liquid crystal display device, the electrode pads and the alignment marks are formed by the same mask. Therefore, the relative positions of the alignment marks to the electrode pads can be set constant.

According to another aspect of the present invention, there is provided a method of manufacturing a liquid crystal display device having a pair of transparent substrates each other with a liquid crystal layer sandwiched, transparent electrodes disposed on surfaces of the transparent substrates on a side of the liquid crystal layer, interconnect wirings for drawing each of the transparent electrodes to one of the transparent substrates, and a control circuit device disposed on the one transparent substrate and connected to the interconnect wirings, the manufacturing method is characterized by including:
forming the transparent electrodes, an ITO film to be connected to the transparent electrodes for drawing the transparent electrodes to one side of the one transparent substrate, and a transparent dummy pad made of ITO are formed at the same time; and
forming a metal layer on the one transparent substrate and then patterning the metal layer with a same mask to laminate the metal film on the ITO film to form the interconnect wirings and the electrode pads.

According to the manufacturing method of the liquid crystal display device, the metal film of forming the interconnect wirings and the electrode pads are formed at the same time. Therefore, the relative positions of the interconnect wirings to the electrode pads can be set constant. Accordingly, the position to mount the control circuit device can be determined accurately.

Preferably, the method is characterized in that alignment marks to be reference for positioning the control circuit device are formed on both sides of the control circuit device at the same time when the metal layer is patterned.

According to the manufacturing method of the liquid crystal display device, the alignment marks are formed at the same time when the metal layer is patterned. Therefore, the relative positions of the alignment marks to the electrode pads can be set constant. Accordingly, the terminals of the control circuit device can be accurately positioned and bonded to the electrode pads.

As described above in detail, according to the liquid crystal display device of the invention, the island transparent dummy pad to be connected to the dummy terminal of the control circuit device is disposed, the island transparent dummy pad is adjacent to the electrode pad but separate from the interconnect wiring. Therefore, the bonding state of the dummy terminal to the transparent dummy pad can be visually recognized from the side where the interconnect wirings are not disposed on the one transparent substrate. Accordingly, the bonding state of the electrode pads to the original terminals can be estimated from the bonding state of the transparent dummy pad to the dummy terminal, and the bonded state of the control circuit device can be visually recognized through the transparent dummy pad.

In addition, according to the liquid crystal display device of the invention, the alignment marks and the metal film of the interconnect wirings are formed at the same time. Therefore, the relative positions of the alignment marks to the interconnect wirings can be set constant. Accordingly, the position to mount the control circuit device can be determined accurately.

Furthermore, the alignment marks are made of the metal film. Therefore, the alignment marks can be recognized along with the control circuit device from the side where the alignment marks are formed, and the control circuit device can be positioned accurately.

Accordingly, it leads to improved productivity and enhanced yields in assembly processes.

Embodiments of the invention will now be described, by way of example only, with reference to the accompanying drawings, in which:
Fig. 1 is an exploded perspective view illustrating a liquid crystal display device of the embodiment according to the invention;
Fig. 2 is an enlarged plan view illustrating an exposed surface on one substrate, which is an essential part of the liquid crystal display device of the embodiment according to the invention;
Fig. 3 is a schematic cross-sectional view illustrating the interconnection part of a control IC, which is an essential part of the liquid crystal display device of the embodiment according to the invention;
Fig. 4 is a schematic plan view illustrating the interconnection part of the control IC, which is an essential part of the liquid crystal display device of the embodiment according to the invention;
Fig. 5 is a process drawing illustrating a manufacturing method of a substrate of the liquid crystal display device of the embodiment according to the invention;
Fig. 6 is a cross-sectional view along line 6-6 shown In Fig. 5;
Fig. 7 is a cross-sectional view along line 7-7 shown in Fig. 5;
Fig. 8 is a process drawing illustrating the manufacturing method of the substrate of the liquid crystal display device of the embodiment according to the invention;
Fig. 9 is a cross-sectional view along line 9-9 shown in Fig. 8;
Fig. 10 is a cross-sectional view along line 10-10 shown in Fig. 8;
Fig. 11 is a perspective cross-sectional view illustrating one example of interconnect wirings of the liquid crystal display device of the embodiment according to the invention;
Fig. 12 is a cross-sectional view illustrating another example of the interconnect wirings of the liquid crystal display device of the embodiment according to the invention;
Fig. 13 is an enlarged plan view illustrating another example of the exposed surface of one substrate;
Fig. 14 is a perspective view illustrating the traditional liquid crystal display device; and
Fig. 15 is a plan view illustrating an essential part of the traditional liquid crystal display device.

### DESCRIPTION OF THE PREFERRED EMBODIMENT

Hereafter, an embodiment of the invention will be described with reference to the drawings.

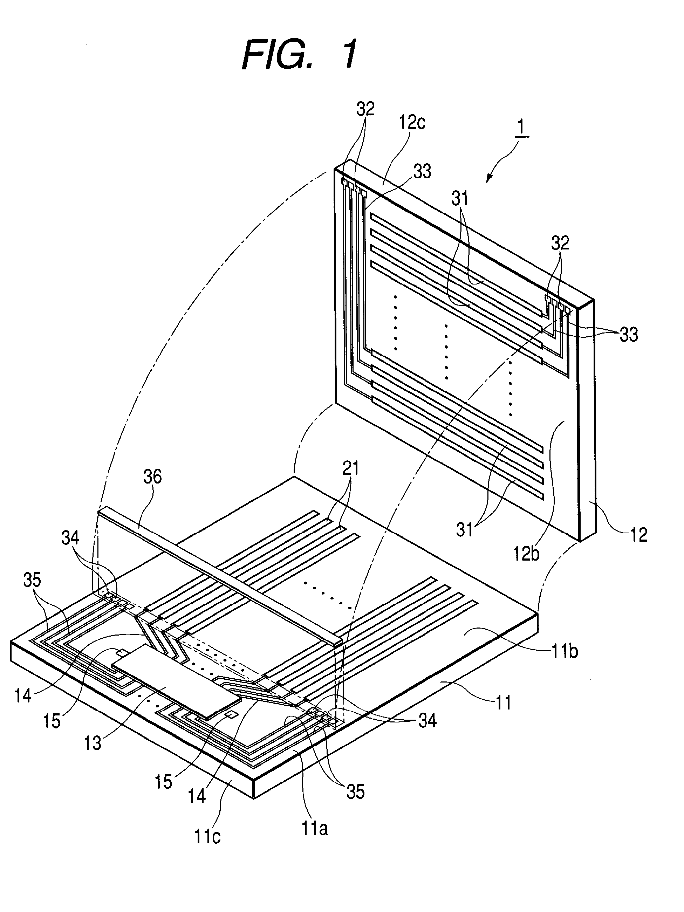

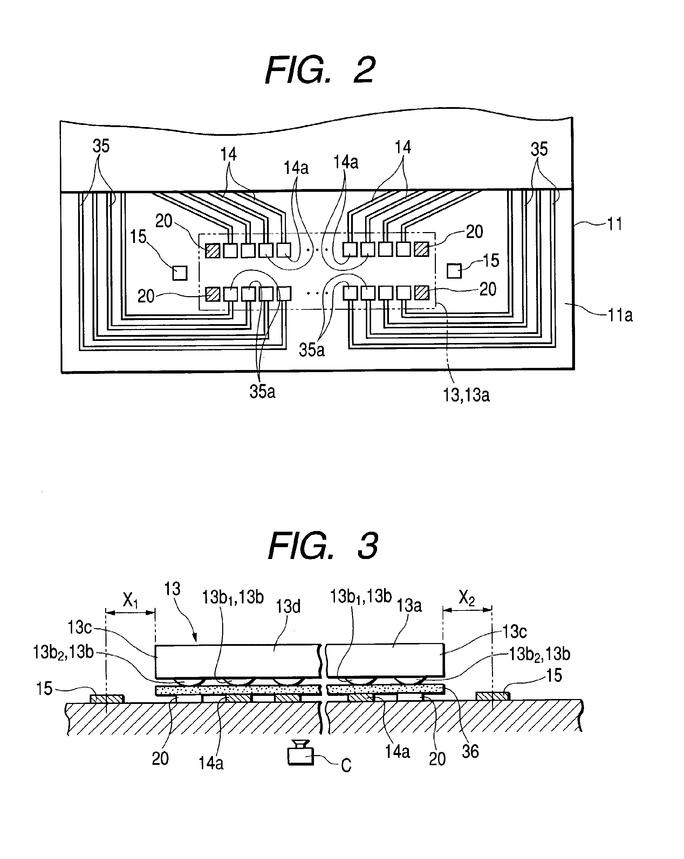

Fig. 1 is a simple matrix liquid crystal display device of an embodiment according to the invention, and Fig. 2 depicts a plan view illustrating an essential part of the liquid crystal display device of the embodiment.

As shown in Fig. 1, a liquid crystal display device 1 of the embodiment is mainly configured of a pair of transparent substrates (first and second transparent substrates) 11 and 12 facing each other with a liquid crystal layer sandwiched, not shown, and a control IC 13 disposed on an exposed surface 11a of the first substrate 11. The first substrate 11 is formed longer in length than the second substrate 12. The portion extending off the second substrate 12 is the exposed surface 11a, and the portion facing the second substrate 12 is a display area surface 11b. The entire surface of the second substrate 12 facing the first substrate 11 is a display area surface 12b.

As shown in Fig. 1, on the display area surfaces 11b and 12b of the substrates 11 and 12, segment transparent electrodes 21 and common transparent electrodes 31 are formed, respectively. The transparent electrodes 21 and 31 are that a plurality of flat strips made of a transparent conductive film such as ITO is arranged. They are separately connected to the control IC 13 for driving liquid crystal molecules configuring the liquid crystal layer. The transparent electrodes 21 and 31 are disposed orthogonal to each other when seen in plane, and the liquid crystal display device 1 is a passive matrix type.

Not shown in the drawing, on each of the display area surfaces 11b and 12b of the first and second substrates 11 and 12, an overcoat film for planarizing recesses and projections generated by the transparent electrodes 21 and 31 and an alignment layer for controlling the alignment of liquid crystal molecules configuring the liquid crystal layer are formed. In addition to this, a color filter and a reflector are formed on the display area surface 11b

On the first substrate 11, interconnect wirings 14 for connecting the transparent electrodes 21 to the control IC 13 are drawn from the display area surface 11b toward the exposed surface 11a (a side 11c). The interconnect wirings 14 are formed of an ITO film and a metal film in which at least a part of the metal film is overlapped with the ITO film.

On the second substrate 12, a plurality of upper electrodes 32 is formed in a row along a side 12c. Additionally, on the second substrate 12, second interconnect wirings 33 for connecting the transparent electrodes 31 to the upper electrodes 32 are formed.

On the display area surface 11b of the first substrate 11, lower electrodes 34 are formed. The lower electrodes 34 are formed at positions corresponding to the positions of the upper electrodes 32. On the first substrate 11, first interconnect wirings 35 for connecting the lower electrodes 34 to the control IC 13 are drawn from the display area surface 11b toward the exposed surface 11a (the side 11c). An anisotropic conductive resin layer 36 is disposed between the upper electrodes 32 and the lower electrodes 34. The anisotropic conductive resin layer 36 contains conductive particles made of metal. The conductive particles are sandwiched between the upper and lower electrodes 32 and 34, and then the upper and lower electrodes 32 and 34 are electrically connected.

Accordingly, the transparent electrodes 31 on the second substrate 12 are electrically connected to the control IC 13 through the second interconnect wirings 33, the upper electrodes 32, the anisotropic conductive resin layer 36, the lower electrodes 34, and the first interconnect wirings 35.

The second interconnect wirings 33 and the first interconnect wirings 35 are all formed of the ITO film and the metal film as similar to the interconnect wirings 14 in which at least a part of the metal film is overlapped with the ITO film.

Next, as shown in Figs. 2 and 3, island electrode pads 14a and 35a formed by drawing the metal film are disposed at the tip ends of the interconnect wirings 14 and 35, respectively.

On both sides of the electrode pads 14a and 35a in the horizontal direction, four transparent dummy pads 20... are formed. The transparent dummy pads 20 are made of a transparent material such as ITO, which are formed into an island shape on the exposed surface 11a

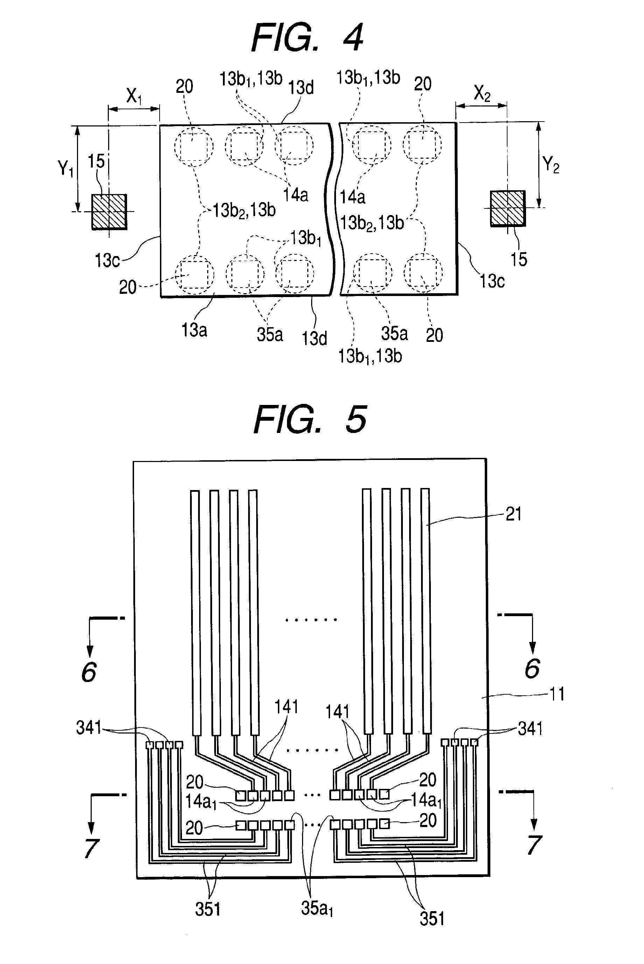

As shown in Figs. 3 and 4, the control IC 13 is configured of a nearly rectangular sealing main part 13a having a semiconductor device incorporated therein when seen in plane and terminals 13b formed of solder balls formed on the lower surface of the sealing main part 13a. The terminals 13b include original terminals 13b1 electrically connected to the semiconductor device inside the sealing main part 13a and dummy terminals 13b2 not to be connected to the semiconductor device. The dummy terminals 13b2 are disposed at positions corresponding to the transparent dummy pads 20.

As shown in Figs. 3 and 4, the terminals 13b of the control IC 13 are separately bonded to the electrode pads 14a and 35a and the transparent dummy pads 20 through the anisotropic conductive resin layer 36. Among the terminals 13b, the original terminals 13b1 are electrically connected to the electrode pads 14a and 35a and the dummy terminals 13b2 are connected to the transparent dummy pads 20.

When the terminals 13b are pressed onto the electrode pads 14a and 35a and the transparent dummy pads 20 through the anisotropic conductive resin layer 36, the conductive particles contained in the anisotropic conductive resin layer 36 are sandwiched and compressed between the terminals 13b and the electrode pads 14a and 35a and the transparent dummy pads 20. Consequently, electrical interconnection is secured. The state that the conductive particles are compressed can be visually recognized easily through the transparent dummy pads 20 from under the substrate 11. Additionally, the bonding state can be confirmed as well by counting the number of the conductive particles bonded to a single transparent dummy pad 20.

The bonding state of the electrode pads 14a and 35a to the original terminals 13b1 can be estimated to be almost similar to the bonding state of the transparent dummy pads 20 to the dummy terminals 13b2. Accordingly, the bonded state of the control IC 13 can be visually recognized through the transparent dummy pads 20.

As shown in Figs. 2 to 4, on both sides of the control IC 13 on the exposed surface 11a alignment marks 15, 15 are formed that are the reference for positioning the control IC 13 in mounting the control IC 13 on the first substrate 11. The alignment marks 15, 15 are formed of an opaque metal film as similar to the electrode pads 14a and 35a, for example, and are formed by the photomask at the same time when the electrode pads 14a and 35a are formed.

Therefore, the relative positions of the alignment marks 15, 15 to the electrode pads 14a and 35a are highly accurate, and variations in every liquid crystal display device are reduced.

To use the alignment marks 15 to mount the control IC 13, a liquid crystal display device is assembled and then delivered to a mounting device for the control IC. Subsequently, a sensor inside the mounting device senses the positions of the alignment marks 15, 15 from under the first transparent substrate 11, and then the liquid crystal display device is positioned at a predetermined position of a jig inside the mounting device based on position data at this time. In this state, the control IC 13 is placed on the exposed surface 11a through an anisotropic conductive tape, and the terminals of the control IC 13b are positioned and bonded to the electrode pads 14a and 35a on the exposed surface 11a.

As shown in Figs. 3 and 4, in positioning the position of the control IC 13, sensor C inside the mounting device senses the relative positions of the sealing main part 13a of the control IC 13 to the alignment marks 15, 15 for positioning as the relative positions are put in contrast with predetermined reference position data of the control IC 13.

More specifically, distances X1 and X2 between the alignment marks 15, 15 and sides 13c along the short sides of the sealing main part 13a of the control IC 13 and distances Y1 and Y2 between the alignment marks 15, 15 and an elongation of a side 13d along the long sides of the sealing main part 13a are measured and put in contrast with the reference data for positioning.

Since the relative positions of the alignment marks 15, 15 to the electrode pads 14a and 35a are accurately positioned, the relative positions of the sealing main part 13a of the control IC 13 to the alignment marks 15, 15 are matched to accurately position the terminals 13b of the control IC 13 to the electrode pads 14a and 35a.

Next, a manufacturing method of the electrode pads 14a and 35a and the transparent dummy pads 20 including the alignment marks 15, 15 and the interconnect wirings 14 and 35 (a manufacturing method of the liquid crystal display device) will be described.

As shown in Figs. 5 to 7, the transparent electrodes 21 made of ITO are formed on the first substrate 11 where the color filter and the reflector have been formed beforehand, and ITO films 141 and 351 forming the interconnect wirings, ITO pads 14a1 at the tip ends of the ITO films 141, ITO lower electrodes 341 at the base ends of the ITO films 351, and ITO pads 35a1 at the tip ends of the ITO film 351 are formed. In addition, the transparent dummy pads 20 made of ITO adjacent to the ITO pads 35a1 are formed.

All of them are formed by laminating an ITO layer and a photoresist throughout the surface of the first substrate 11, layering a photomask for patterning, and exposing them to remove the photomask and the photoresist.

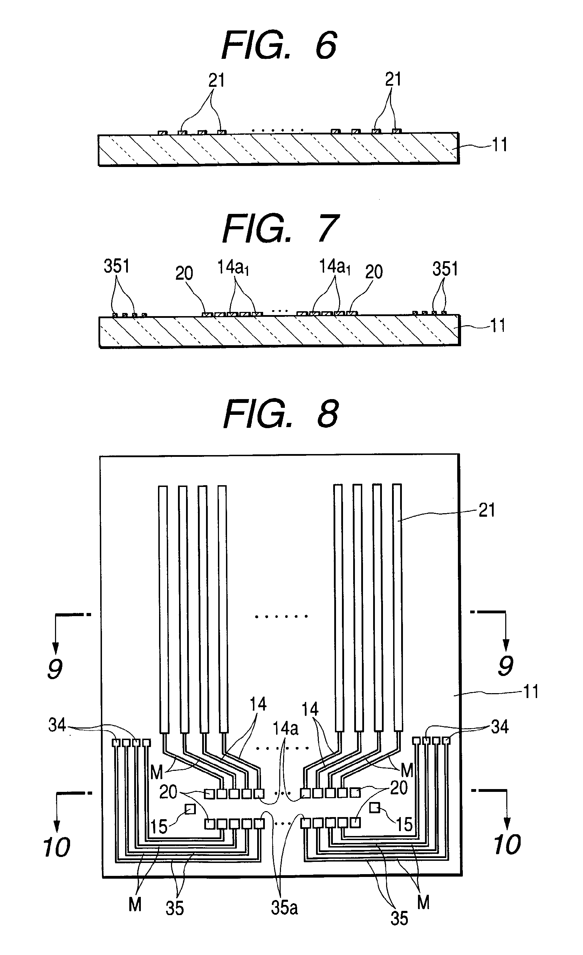

Next, as shown in Figs. 8 to 10, metal film M is formed on the ITO films 141 and 351 forming the interconnect wirings, the ITO pads 14a1 and 35a1, and the ITO lower electrodes 341, and the alignment marks 15, 15 made of the metal film are formed.

The metal film and the alignment marks 15 are all formed by laminating a metal layer and a mask for patterning throughout the surface of the first substrate 11, and etching and patterning the metal layer to remove the mask.

Furthermore, the metal film is not formed on the transparent dummy pads 20.

In this manner, the electrode pads 14a and 35a and the alignment marks 15 including the transparent electrodes 21 and the interconnect wirings 14 and 35 are formed on the first substrate 11. The interconnect wirings 14 and 35, the electrode pads 14a and 35a, and the lower electrodes 34 are all formed by laminating the ITO film and the metal film. The alignment marks 15 are formed of the metal film separately. The transparent dummy pads 20 are formed of the ITO film separately.

The alignment marks 15, 15 are formed by the mask used in forming the metal film at the same time when the metal film is formed. Accordingly, the relative positions of the alignment marks 15 to the electrode pads 14a and 35a can be positioned accurately.

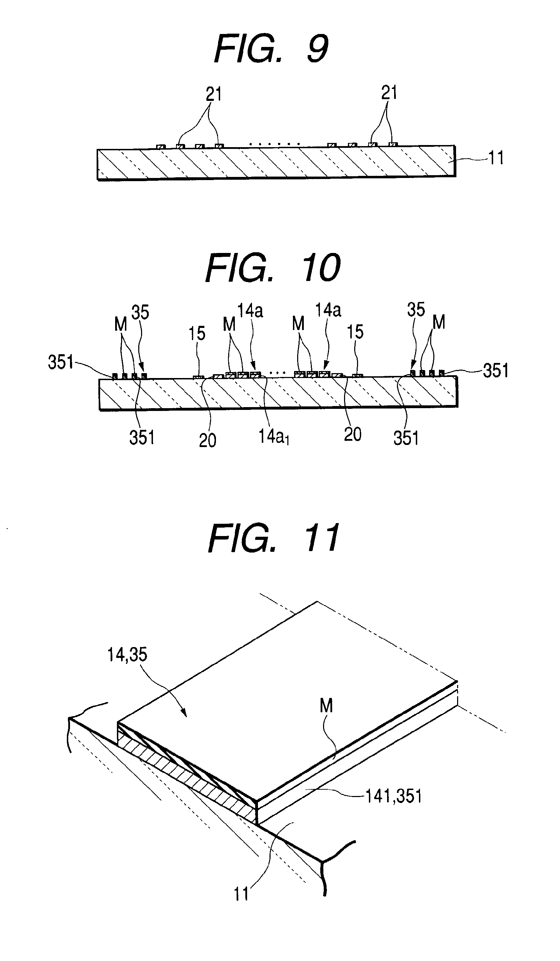

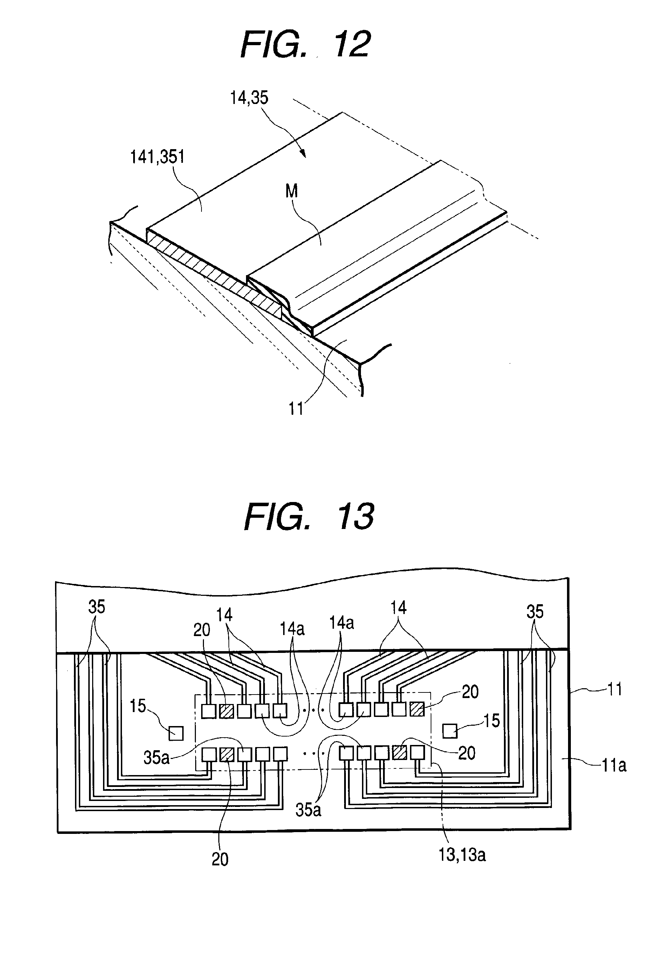

More specific exemplary configurations of the interconnect wiring 14, 35 thus formed are shown in Figs. 11 and 12.

In an interconnect wiring 14, 35 shown in Fig. 11, an ITO film 141, 351 is formed on a substrate 11, metal film M is laminated throughout the surface of the ITO film 141, 351, and the metal film M is formed along the ITO film 141, 351.

In an interconnect wiring 14, 35 shown in Fig. 12, an ITO film 141, 351 is formed on a substrate 11, a part of metal film M is laminated on the ITO film 141, 351, and the metal film M is formed along the ITO film 141, 351.

In Figs. 11 and 12, it is acceptable that the metal film M is formed on the substrate 11 and a part or all of the ITO film 141, 351 is laminated on the metal film M.

A part or all of the metal film is laminated on the ITO film, and thus low conductivity of the ITO film can be compensated by the high conductive metal film. Accordingly, resistance of the interconnect wirings 14 and 35 is reduced to prevent display unevenness from being generated in the liquid crystal display device.

In the embodiment, four transparent dummy pads 20 were disposed at four corners of the control IC 13, but the invention is not limited to this. For example, as shown in Fig. 13, it is fine to dispose them at arbitrary positions between the electrode pads 14a and 35a. Furthermore, as shown in Fig. 13 the number of the transparent dummy pads 20 is not necessarily four. For example, to dispose three dummy pads is acceptable.

## Claims

1. A liquid crystal display device comprising:
a pair of substrates facing each other with a liquid crystal layer sandwiched;
transparent electrodes disposed on surfaces of the substrates on a side of the liquid crystal layer;
interconnect wirings for drawing each of the transparent electrodes to one of the substrates; and
a control circuit device disposed on the one substrate and connected to the interconnect wirings,
wherein at least a part or all of the interconnect wirings are configured by laminating a metal film on a part or all of an ITO film,
alignment marks to be reference for positioning the control circuit device are formed on both sides of the control circuit device on the substrate, and
the alignment marks are formed of a same component material as that of the metal film of the interconnect wirings.

2. The liquid crystal display device according to claim 1, wherein the alignment marks and the metal film of the interconnect wirings are formed at the same time.

3. The liquid crystal display device according to claim 2, wherein the alignment marks and the metal film of the interconnect wirings are formed by forming the metal film on the one substrate and then patterning the metal film with a same mask.

4. The liquid crystal display device according to claim 1, wherein an electrode pad made of the metal film to be connected to a terminal of the control circuit device is formed at tip ends of the interconnect wirings, and the alignment marks and the electrode pads are formed at the same time.

5. The liquid crystal display device according to claim 4, wherein the electrode pads and the alignment marks are formed by forming a metal layer on the one substrate and then patterning the metal layer with a same mask.

6. A method of manufacturing a liquid crystal display device having a pair of substrates facing each other with a liquid crystal layer sandwiched, transparent electrodes disposed on surfaces of the substrates on a side of the liquid crystal layer, interconnect wirings for drawing each of the transparent electrodes to one of the substrates, and a control circuit device disposed on the one substrate and connected to the interconnect wirings, the manufacturing method comprising:
forming a metal layer on the one substrate and then patterning the metal layer with a same mask to form alignment marks to be reference for positioning the control circuit device on both sides of the control circuit device at the same time when the interconnect wirings are formed.

7. The manufacturing method of the liquid crystal display device according to clam 6, wherein an electrode pad made of the metal film to be connected to a terminal of the control circuit device is formed at tip ends of the interconnect wirings , and the alignment marks and the electrode pads are formed at the same time.

8. The manufacturing method of the liquid crystal display device according to clam 7, wherein the electrode pads and the alignment marks are formed by patterning the metal layer with the mask.

9. A liquid crystal display device comprising:
a pair of transparent substrates facing each other with a liquid crystal layer sandwiched;
transparent electrodes disposed on surfaces of the transparent substrates on a side of the liquid crystal layer;
interconnect wirings for drawing each of the transparent electrodes to one of the transparent substrates; and
a control circuit device disposed on the one transparent substrate and connected to the interconnect wirings,
wherein the control circuit device is formed with a dummy terminal not to be connected to the interconnect wiring,
an electrode pad to be connected to an original terminal of the control circuit device is formed at a tip end of each of the interconnect wirings, and
an island transparent dummy pad to be connected to the dummy terminal of the control circuit device is disposed, the island transparent dummy pad is adjacent to the electrode pad but separate from the interconnect wiring.

10. The liquid crystal display device according to claim 9, wherein at least a part or all of the interconnect wirings are configured by laminating a metal film on a part or all of an ITO film, the electrode pad is formed of at least the metal film, and the transparent dummy pad is formed of ITO.

11. The liquid crystal display device according to claim 10, wherein alignment marks made of the metal film to be reference for positioning the control circuit device are formed on both sides of the control circuit device on the transparent substrate, and the alignment marks and the electrode pads are formed at the same time.

12. The liquid crystal display device according to claim 11, wherein the electrode pads and the alignment marks are formed by forming a metal layer on the one transparent substrate and then patterning the metal layer with a same mask.

13. A method of manufacturing a liquid crystal display device having a pair of transparent substrates each other with a liquid crystal layer sandwiched, transparent electrodes disposed on surfaces of the transparent substrates on a side of the liquid crystal layer, interconnect wirings for drawing each of the transparent electrodes to one of the transparent substrates, and a control circuit device disposed on the one transparent substrate and connected to the interconnect wirings, the manufacturing method comprising:
forming the transparent electrodes, an ITO film to be connected to the transparent electrodes for drawing the transparent electrodes to one side of the one transparent substrate, and a transparent dummy pad made of ITO on the one transparent substrate; and
forming a metal layer on the one transparent substrate and then patterning the metal layer with a same mask to laminate the metal film on the ITO film to form the interconnect wirings and the electrode pads.

14. The manufacturing method of the liquid crystal display device according to clam 13, wherein alignment marks to be reference for positioning the control circuit device are formed on both sides of the control circuit device at the same time when the metal layer is patterned.
